# EUROPEAN PATENT SPECIFICATION

(11) **EP 2 837 082 B1**
(45) Date of publication and mention of the grant of the patent: **14.09.2016**
(21) Application number: 13773873.8
(22) Date of filing: 27.03.2013
(51) Int. Cl.: G01R 31/36, H02J 9/06, H02J 7/00

(54) **METHOD AND SYSTEM FOR REMOTE MEASUREMENT OF AVAILABLE CAPACITY OF THE BATTERIES IN THE TELECOMMUNICATIONS POWER SYSTEM**
VERFAHREN UND SYSTEM FÜR DISTANZMESSUNG DER VERFÜGBAREN KAPAZITÄT VON BATTERIEN IN EINEM TELEKOMMUNIKATIONSSYSTEM
PROCÉDÉ ET SYSTÈME POUR LA MESURE À DISTANCE DE LA CAPACITÉ DISPONIBLE DES BATTERIES DANS UN SYSTÈME D'ALIMENTATION POUR LES TÉLÉCOMMUNICATIONS

(30) Priority: 11.04.2012 PL 39879112
(43) Date of publication of application: 18.02.2015
(73) Proprietor: Instytut Lacznosci Panstwowy Instytut Badawczy, 04-894 Warszawa (PL)
(72) Inventor: GODLEWSKI, Pawel, PL-04-955 Warszawa (PL); KOBUS, Ryszard, PL-01-926 Warszawa (PL); CHOJNACKI, Bogdan, PL-01-355 Warszawa (PL); NIECHODA, Kazimierz, PL-04-331 Warszawa (PL); OLECHOWSKI, Krzysztof, PL-03-909 Warszawa (PL); KLIS, Pawel, PL-02-530 Warszawa (PL); GRUNT, Marek, PL-78-400 Szczecinek (PL)
(74) Representative: Karczmitowicz, Teresa Ewa
(86) International application number: PCT/PL2013/000041
(87) International publication number: WO 2013/154444

(56) References cited:
- WO-A1-2010/033076
- US-A1- 2006 261 783
- US-A1- 2009 325 056
- US-A1- 2011 089 907
- US-A1- 2011 227 414
- US-A1- 2011 298 626
- US-B1- 6 240 337

## Description

The present invention relates to a method and a system for remote measurement of available capacity of the batteries in the telecommunications power system, which are the energy reserve for the telecommunication facilities mainly those comprised in the telecommunications critical infrastructure. For these purposes e.g. lead-acid batteries (typically VRLA or AGM, with a capacity of one hundred to several hundreds of Ah) are used.

To ensure continuous operation of the technical infrastructure in the telecommunications network, uninterrupted power supply even in case of power failure in the power grid 230/400V is required. Therefore, a typical power system for the telecommunications equipment in the facility consists of the power station with the mains voltage rectifiers fed with 230/400V and the backup power source consisting of at least two chains of batteries (typically lead-acid batteries), usually of nominal voltage of 48 V, connected to the energy receivers, i.e. the loads.

In known and commonly used power systems, at least two batteries are interconnected through the fuses and are connected to the outputs of the rectifier units (rectifiers) connected to the energy receivers, or loads, through common battery cut-out contactor controlled by a microprocessor controller. The latter communicates with the centralized monitoring system of the power station. In normal operating conditions the rectifiers provide the energy receivers and the batteries with the "buffering voltage", and then the batteries fed with low preservative current are not discharged. In case of power failure in the power grid both batteries take the energy supply to the energy receivers, and after returning of voltage the rectifiers again provide power to the devices while charging both batteries. Energy security of the facility depends on the availability of energy in the power grid, and in case of deficiency - from the amount of energy stored in both batteries. Manufacturers determine the battery life time of 5-10-20 years (depending on technology), but disadvantageous operating conditions cause their degradation, i.e. reduction of available capacity below 80% of nominal value often in half of this time. Batteries should therefore be either exchanged frequently, which is an expensive procedure, or checked and replaced if out of order.

The most accurate method of assessing available capacity is a controlled discharge with a preset current, usually with so-called 10-hours current or 20-hours current. This method measures the capacity of the battery "manually" switched-off from the load - by discharge rheostats maintaining a constant discharge current or by automatic devices TBA2-IL, TBA150-x-IL, TBA160-IL, which in practice allows to assess the available capacity with accuracy better than ±2 %.

The disadvantage of known solutions is a need for participation of the servicing personnel in the monitoring process lasting from 20 to 40 hours, which requires disconnecting of the battery from the rectifiers and loads, connecting it to the controller, and after ending the testing procedure - re-connecting the battery to the rectifiers and the loads in the power system.

Polish patent PL201960 B1 discloses the converter system for the telecommunication DC power system with two batteries which eliminates the need for participation of the servicing personnel. In this system, during controlled discharge-charge procedure with the DC programmed current, the converter disconnects through its two relays with switchable contacts selected battery from the power station circuit and connects it to the converter built from transistors, capacitors and inductor. A well-known drawback of this solution is a large current flowing through the relay contacts inside the device in the state of the loads supply from the battery and also the need to switch-off both batteries for disassembly of the appliance for repair or maintenance.

Polish patent application PL390982 A1 discloses a method and a system for remote diagnostics of the batteries, especially in the ICT systems. According to this solution, in the power system an additional separated bus is connected to the batteries through individual lines, by another contactor to the rectifier units, through another contactor to a group of selected energy loads, and through yet another contactor it is connected during normal bus operation to the system negative bus of the power station. The disadvantage of this solution is a large number of high-current power contactors connecting the loads, complicated procedure of discharging controlled battery with the DC current by adjusting the output current in a separate, tailored to that function group of rectifiers, and limited ability to use energy stored in controlled battery to maintain supply of the loads in case of power failure in the power grid.

From American patent application US2009021216 A1 is known a solution for charging and remotely managed controlled discharging of two batteries, where individual electronic contactors, made of transistors, are used to connect the loads to the rectifiers and to each of the batteries, and individual for each battery charging systems. The disadvantages of this solution are as follows: the electronic switches are sensitive to shocks and instabilities of the network and are susceptible to cause the energy loss, value of the discharging current is determined by the loads which may change over time, instead of the preferred 10-hours current or 20-hours current, and inability to use the energy of controlled battery to sustain the load in case of the power failure in the power grid, because one cannot directly connect two batteries with different levels of charge/discharge to the energy receivers.

American patent application US2011/298626 A1 describes a system and method for monitoring the status of a system of battery strings. The system includes a current sensor for each of the battery strings, and a controller configured to compare the measured current with criteria to determine whether the battery is in a thermal runaway state. Prior to entering the thermal runaway state the battery current characteristics may indicate other less serious states. Warning messages are provided for selected events, and the battery string is disconnected from the remainder of the system when a thermal runaway state is encountered. The system may provide a local indication of status and may also interface with a communications network to provide for remote monitoring. This solution is dedicated for the power systems like Telco systems and UPS with built-in monitoring of batteries, where individual relays are used to disconnect the battery strings from the power system if thermal runaway is detected.

American patent applications US2009/325056 A1 and US2011/089907 A1 disclose the power source that includes a set of cells and a main power bus configured to connect the set of cells in a parallel configuration. The power source also includes a bidirectional converter configured to connect to one cell from the set of cells at a time. It also includes a set of switches configured to switch each cell in the set of cells to one of the main power bus and the bidirectional converter. This is a solution for managing parallel connected cells of batteries used in portable equipment with built in bidirectional converter. All processes in the battery pack, calibration included, are fully autonomously controlled by an internal microcontroller and performed with bidirectional converter and measurement unit connected to each cell. Assessment of the cell capacity is based on measurement of the cell resistance and is used to estimate the cell state. Results of calibration are used to optimize connection of cells to main power bus either directly or via bidirectional converter.

Another American patent application US2011/227414 A1 describes systems, apparatuses, and methods for managing battery circuits in systems such as wireless communications service base stations. An example apparatus includes a battery circuit having multiple strings of one or more serially connected batteries. The apparatus may be configured to rotate between battery strings such that one or more strings are maintained at or near an upper threshold while other string(s) are disconnected from the maintained string(s). The apparatus may also be configured to charge the battery circuit, to test the battery circuit, and to handle power failures.

International patent application WO2010/033076 A1 describes a battery pack burn-in test system comprising first and second interconnection circuits for electrically interconnecting a first and a second battery pack respectively to the system; a data communication bus for coupling to respective battery management integrated circuits of the first and second battery packs; and a system management unit coupled to the data communication bus. The system management unit may control a charging of the first battery pack during a burn-in test from a discharging of the second battery pack.

American patent US6240337 B1 eliminates problems caused by the use of batteries for back-up power in outside plant facilities of a communication network or the like, by replacement of the batteries with flywheel reserve power systems. Specific applications of flywheel power systems include the optical terminal of a digital loop carrier type system, for a telephone network, or the optical network units in fiber to the curb or fiber to the home type communication networks. In the preferred embodiments, the flywheel power systems include intelligent components for monitoring and controlling operations of the power systems. Communication links are provided, to enable the monitoring and control components to report status to and receive control instructions from a centralized network control or management center.

American patent application US2006/261783 A1 discloses a telecommunication switching station that includes telecommunication equipment, a DC power supply having an output connected to the telecommunication equipment, and a plurality of rechargeable DC power supplies connected in parallel with the output of the DC power supply. Each DC power supply includes a pair of power supply terminals, a rechargeable battery, and a bidirectional DC-DC converter module connected between the rechargeable battery and the pair of power supply terminals. The DC power supply provides power to the telecommunication equipment and recharges the plurality of rechargeable DC power supplies. The plurality of rechargeable DC power supplies serve as a back-up for the DC power supply.

The method for remote measurement of available capacity of the batteries in the telecommunications power system according to the invention is characterized in that in order to initiate remotely an individual discharge for each of at least two batteries, the system negative bus in the power station is connected to the terminals individual for each of the batteries, normally switched-on (and acting as low-voltage switches) of high-current contactors, the second contacts of which are connected, either directly or through the fuses, to the negative poles of the battery, respectively, while these poles are connected through the low-current contactors directly, or through the fuses, to the second input of the controlling-measuring device connected by the third input to the system negative bus and by the first input to the system positive bus, while the third input of the controlling-measuring device is connected to the third input of the additive-subtractive converter, the first input of the controlling-measuring device is connected to the ground input of the additive-subtractive converter, a second input of the controlling-measuring device is connected through the current measurement subsystem to the second input of the additive-subtractive converter, while the microprocessor control unit connected to the remote monitoring center is connected by the individual lines to the control inputs and high-current contactors and low-current contactors, and to the communication interface of the controlling-measuring device. The microprocessor control unit through one of high-current contactors disconnects the battery designated for testing from the system negative bus, and through respective low-current contactor connects it to the first input of the controlling-measuring device and then after controlled discharging followed by charging, disconnects tested battery from the controlling-measuring device, and connects it through the high-current contactor to the system negative bus, while the controlling-measuring device on a command from the microprocessor control unit autonomously carries out a test comprising discharge of the battery designated for testing with a current controlled by an internal current measurement subsystem, directing energy taken from the battery to the load of the power system, and then immediately, taking energy from the rectifier units, charges the battery with controlled by the current measurement subsystem the 10-hours current or the 20-hours current up to the preset voltage, and after the preset charging time it terminates the process, passing cumulative result of testing to the microprocessor control unit, while the controlling-measuring device on a command from the microprocessor control unit can only perform an equalizing charging of the battery, and after the preset time it ends the process, passing the cumulative result of charging to the microprocessor control unit.

Besides, in the process of testing the battery, the controlling-measuring device at a voltage loss in the power grid switches to the battery discharge regime, maintaining the power supply to the load of the power system with energy stored in this battery, while it autonomously controls the internal additive-subtractive converter so that the voltage on the third output of this converter equals to the voltage on the system negative bus, and from the battery disconnected for testing the preset current is taken, while in the process of testing the battery the controlling-measuring device, after finding the voltage is restored in the power grid from the voltage increase at the system negative bus or on the signal from the microprocessor control unit, either continues discharging the battery, or realizes its charging combined with the equalizing charging.

The system for remote measurement of available capacity of the battery in the telecommunications power system according to the invention is characterized in that the system negative bus of the power system is connected to the terminals individual for each of the batteries, normally switched-on (and acting as low-voltage switches) the high-current contactors, the second contacts of which are connected, either directly or through the fuses, to the negative poles of respective battery, wherein these poles are connected by the low-current contactors directly, or preferably through the fuses, to the second input of the controlling-measuring device connected with the third input to the system negative bus, and with the first input to the system positive bus, in which the third input is connected to the third input of the additive-subtractive converter, the first input is connected to the ground input of the additive-subtractive converter, and the second input is connected through the current measurement subsystem to the second input of the additive-subtractive converter, wherein the microprocessor control unit is connected by individual lines with the control inputs of the high-current contactors and the low-current contactors, and with the communication interface of the controlling-measuring device, and besides the low-current contactors can be advantageously integrated with the controlling-measuring device and switched on by this controlling-measuring device.

The advantage of the invention is the ability to implement, without assistance of the servicing personnel, a measurement of available capacity of the battery being the energy reserve for the telecommunications facilities, while this measurement is carried with the most reliable method of measurement discharge with use of constant 10-hours current or 20-hours current with a minimum energy loss of 5%. Modifications to the electrical system of the power system, in conjunction with the controlling-measuring device, make it possible to initiate remotely the controlled discharge testing procedure of available capacity of each battery used in the power system, mainly of a voltage of 48V, by automatically: disconnecting the battery selected for testing from the power system, its full equalizing charging, followed by the controlled discharge (by downloading a specific or maximum charge), and then charging the battery and re-connecting it to the power system. In case of the power failure in the power grid the energy stored in the battery disconnected for measurement will be transferred to the load in the power system, thus helping other batteries, not disconnected for control.

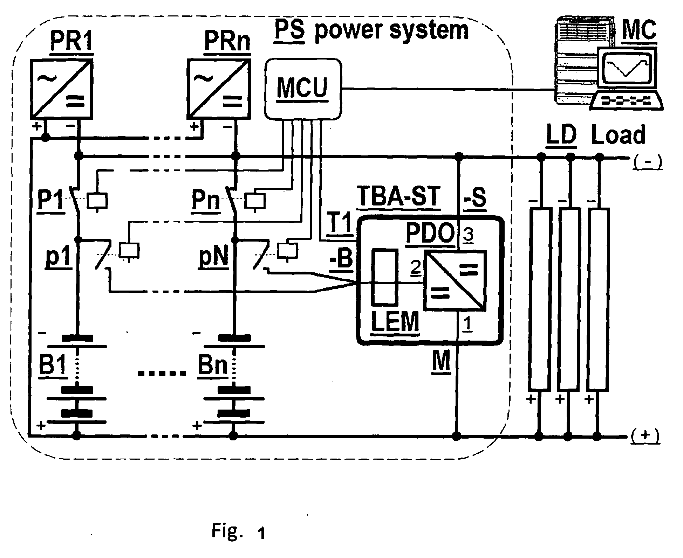

An embodiment of invented system for remote measurement of available capacity of the batteries in the telecommunications power system is illustrated on the drawing showing a block diagram of the system.

The method of remote measurement of available capacity of the batteries in the telecommunications power system, according to the invention, is implemented as follows: in the modified power system (PS) controlled by the remote monitoring center (MC) with the microprocessor control unit (MCU), the controlling-measuring device (TBA-ST) is installed permanently so that its communication input (T1) is connected to one of the outputs of the microprocessor control unit (MCU), the first input (M) is connected to the system positive bus (+), the third input (-S) is connected directly or through the fuse to the system negative bus (-), and the second input (-B) is connected either directly or through the fuses to the contacts of the low-current contactors (p1, pN) of this power system (PS). The controlling-measuring device (TBA-ST) comprises bidirectional additive-subtractive converter (PDO), through which it transfers energy in both directions, during discharging of the battery by reduction or increase of voltage on the second input (-B), and during charging of the battery by reduction or increase of voltage on the third input (-S), while the required current flowing through the second input (-B) from/to the battery is measured using a precise current measurement system (LEM). In response to the command sent from the remote monitoring center (MC), through the appropriate output of the microprocessor control unit (MCU) the battery (B1, Bn) designated for testing is disconnected using the appropriate (acting also as a low-voltage switch) high-current contactor (P1, Pn) and connected by a suitable low-current contactor (p1, pN) to the second input (-B) of the controlling-measuring device (TBA-ST). After sending by the microprocessor control unit (MCU) of the command to test the battery and after verification of its connection to the second input (-B) of the controlling-measuring device (TBA-ST) the testing procedure is performed in which after equalizing charging of the battery it is discharged with stabilized current of preset value until the battery or its mono-blocks reach preset voltage, or until the preset charge is taken from the battery. Energy from discharged battery is transmitted to the load (LD) through the third input (-S) of the controlling-measuring device (TBA-ST), thus unloading the rectifier units (PR1, PRn). Immediately after the discharge of the battery it is charged with preset current to the specified voltage. Energy to charge the batteries is taken from the rectifier units (PR1, PRn) through the third input (-S). At the end of the procedure the result of the battery test is sent to the microprocessor control unit (MCU) and further by transmission link or data network to the remote monitoring center (MC). and then the low-current contactor (p1, pN) disconnects the battery from the controlling-measuring device (TBA-ST) and subsequently the battery is connected with the high-current contactor (P1, Pn) to the rectifier units (PR1, PRn) and the load (LD).

In the system for remote measurement of the available capacity of the battery in the telecommunications power system (PS), according to the invention, the positive poles of at least two batteries (B1, Bn), the positive poles of the load (LD), the outputs of the rectifier units (PR1, PRn), and the first input (M) of the controlling-measuring device (TBA-ST) are connected to the system positive bus (+), while the system negative bus (-) is connected to the negative poles of the load (LD) and to the negative outputs of the rectifier units (PR1, PRn), to the third input (-S) of the controlling-measuring device (TBA-ST) and to the contacts, individual for each battery, of the high-current contactors (P1, Pn), the second contacts of which are connected through the fuses to the negative poles of respective batteries (B1, Bn), and these poles are connected through the low-current contactors (p1, pN) directly or through the fuses to the second input (-B) of the controlling-measuring device (TBA-ST). The third input (-S) of the controlling-measuring device (TBA-ST) is connected to the third input (3) of the additive-subtractive converter (PDO), the first input (M) of the controlling-measuring device (TBA-ST) is connected to the ground input (1) of the additive-subtractive converter (PDO), the second input (-B) of the controlling-measuring device (TBA-ST) is connected through the current measurement system (LEM) to the second input (2) of the additive-subtractive converter (PDO). The microprocessor control unit (MCU) is connected by transmission link or data network to the remote monitoring center (MC) and through individual lines to the control inputs of the high-current contactors (P1, Pn), the low-current contactors (p1, pN) and to the communication connector (T1) of the controlling-measuring device (TBA-ST).

The measurement procedure of discharging and charging of the battery involves constant over time, preset 10-hours current or 20-hours current. If during this measurement procedure a loss of voltage in the power grid would appear, which will be indicated by reduced voltage on the system negative bus (-), the controlling-measuring device (TBA-ST) irrespective of the status of work, will switch into the state "power assist", accordingly increasing or decreasing the voltage at its third input (-S), and the energy from the battery in a manner safe for the contactors and other batteries will support the remaining batteries, supplying the load (LD) until controlled battery is fully discharged or until voltage on the system negative bus (-) increases, which means that the utility power in the power grid is available again.

## Claims

1. A method of remote measurement of available capacity of the batteries in the telecommunication power system, **characterized in that** it is controlled remotely by a remote monitoring center (MC) connected by transmission link or data network with a microprocessor control unit (MCU), and comprises a controlled discharge of the battery (B1, Bn) with use of a controlling-measuring device (TBA-ST), with preset constant current, where in order to initiate remotely an individual discharge for each of at least two batteries (B1, Bn), the system negative bus (-) in the power system (PS) is connected to the terminals individual for each of the batteries (B1, Bn), normally switched-on and acting as low-voltage switches, of high-current contactors (P1, Pn), the second contacts of which are connected, either directly or through the fuses, to the negative poles of the battery (B1, Bn), while these poles are connected through the low-current contactors (p1, pN) directly, or through the fuses, to the second input (B) of the controlling-measuring device (TBA-ST) connected by the third input (-S) to the system negative bus (-) and by the first input (M) to the system positive bus (+), while the third input (-S) of the controlling-measuring device (TBA-ST) is connected to the third input (3) of the additive-subtractive converter (PDO), the first input (M) of the controlling-measuring device (TBA-ST) is connected to the ground input (1) of the additive-subtractive converter (PDO), a second input (-B) of the controlling-measuring device (TBA-ST) is connected through the current measurement subsystem (LEM) to the second input (2) of the additive-subtractive converter (PDO), while the microprocessor control unit (MCU) connected to the remote monitoring center (MC) is connected by the individual lines to the control inputs and high-current contactors (P1, Pn) and low-current contactors (p1, pN), and to the communication interface (T1) of the controlling-measuring device (TBA-ST).

2. The method according to claim 1 **characterized in that** the microprocessor control unit (MCU) through one of the high-current contactors (P1, Pn) disconnects the battery (B1, Bn) designated for testing from the system negative bus (-), and through respective low-current contactor (p1, pN) connects it to the first input (-B) of the controlling-measuring device (TBA-ST), and after terminating the testing, procedure disconnects tested battery from the controlling-measuring device (TBA-ST) and connects it through the high-current contactor (P1, Pn) to the system negative bus (-).

3. The method according to claim 1 **characterized in that** the controlling-measuring device (TBA-ST) on the command from the microprocessor control unit (MCU) autonomously carries out a test comprising discharge of the battery (B1, Bn) designated for testing with a current controlled by an internal current measurement subsystem (LEM), directing energy taken from the battery (B1, Bn) to the load (LD) of the power system (PS), and then immediately, taking energy from the rectifier units (PR1, PRn), charges the battery with controlled by the current measurement subsystem (LEM) the 10-hours current or the 20-hours current up to the preset voltage, and after the preset charging time it terminates the process, passing cumulative result of testing to the microprocessor control unit (MCU).

4. The method according to claim 1 **characterized in that** the controlling-measuring device (TBA-ST) on the command from the microprocessor control unit (MCU) performs only equalizing charging of the battery (B1, Bn), and after the preset time it ends the process, passing the cumulative result of charging to the microprocessor control unit (MCU).

5. The method according to claim 1 **characterized in that** in the process of testing the battery, the controlling-measuring device (TBA-ST) at a voltage loss in the power grid switches to the battery discharge regime, maintaining the power supply to the load (LD) of the power system (PS) with energy stored in this battery (B1, Bn), while it autonomously controls the internal additive-subtractive converter (PDO) so that the voltage on the third output (-S) of this converter equals to the voltage on the system negative bus (-), and from the battery (B1, Bn) disconnected for testing the preset current is taken.

6. The method according to claim 5 **characterized in that** in the process of testing the battery the controlling-measuring device (TBA-ST), after finding the voltage is restored in the power grid from the voltage increase at the system negative bus (-) or on the signal from the microprocessor control unit (MCU), either continues discharging the battery (B1, Bn), or realizes its charging combined with the equalizing charging.

7. The method according to any of claims 1-6 **characterized in that** the final result of available capacity measurement is sent to the microprocessor control unit MCU and in next step to the remote monitoring center (MC).

8. A system for remote measurement of available capacity of the batteries in the telecommunication power system **characterized in that** it comprises the power system (PS) which is connected to the load (LD) and to the remote monitoring center (MC) connected by transmission link or data network with the microprocessor control unit (MCU), the rectifier units (PR1, PRn) and at least two batteries (B1, Bn) connected through the contactors, and where the positive terminals of the battery (B1, Bn) are connected to the positive system bus (+) of the power system (PS), the positive poles of the load (LD) and the positive outputs of the rectifier units (PR1, PRn), the negative outputs of which are connected to the system negative bus (-), which is connected also to the negative poles of the load (LD), and where the system negative bus (-) of the power system (PS) is connected to the terminals individual for each of the batteries (B1, Bn), the high-current contactors (P1, Pn), the second contacts of which are connected, either directly or through the fuses, to the negative poles of respective battery (B1, Bn), wherein these poles are connected by the low-current contactors (p1, pN) directly, or preferably through the fuses, to the second input (-B) of the controlling-measuring device (TBA-ST) connected with the third input (-S) to the system negative bus (-), and with the first input (M) to the system positive bus (+), in which the third input (-S) is connected to the third input (3) of the additive-subtractive converter (PDO), the first input (M) is connected to the ground input (1) of the additive-subtractive converter (PDO), and the second input (-B) is connected through the current measurement subsystem (LEM) to the second input (2) of the additive-subtractive converter (PDO), wherein the microprocessor control unit (MCU) is connected by individual lines with the control inputs of the high-current contactors (P1, Pn) and the low-current contactors (p1, pN), and with the communication interface (T1) of the controlling-measuring device (TBA-ST).

9. The system according to claim 8 **characterized in that** the low-current contactors (p1, pN) are integrated with the controlling-measuring device (TBA-ST) and are activated by this controlling-measuring device (TBA-ST).

## Patentansprüche

1. Verfahren zur Fernmessung der verfügbaren Kapazität von Akkumulatoren im Telekommunikation-Versorgungssystem, **dadurch gekennzeichnet, dass** es über ein ferngesteuertes Überwachungszentrum (MC) gesteuert wird, das über eine Übertragungsleitung oder Netzwerk mit einem Mikroprozessor-Steuergerät (MCU) verbunden ist, umfassend die gesteuerte Batterieentladung (B1, Bn) mittels eines Kontrollund Messgeräts (TBA-ST), mit Gleichstromversorgung, wobei zur Ferninitiierung der individuellen Batterieentladung jeder der mindestens zwei Batterien (B1, Bn), die Minus-Systemschiene (-) im Versorgungssystem (PS) an individuelle Klemmen für jede Batterie (B1, Bn), Öffner und als Niederspannungsschalter wirkende (P1, Pn) angeschlossen ist, deren zweite Kontakte direkt oder über Sicherung mit den Minuspolen der Batterie (B1, Bn) verbunden sind, wobei diese Pole über Kleinstromkontakte (p1, pN) direkt oder über Sicherungen mit dem zweiten Eingang (B) des Kontroll- und Messgeräts (TBA-ST) verbunden sind, der mit dem dritten Eingang (-S) mit der Minus-Systemschiene (-) und über den ersten Eingang mit der Plus-Schiene (+) des System verbunden ist, wobei der dritte Eingang (-S) des Kontroll- und Messgeräts (TBA-ST) mit dem dritten Eingang (3) des additiv-subtrahierenden Konverters (PDO) verbunden ist; der erste Eingang (M) des Kontroll- und Messgeräts ist mit dem Erdungseingang (1) des additiv-subtrahierenden Konverters (PDO) verbunden; der zweite Eingang (-B) des Kontroll- und Messgeräts (TBA-ST) ist über das Strommess-Subsystem (LEM) mit dem zweiten Eingang (2) des additiv-subtrahierenden Konverters (PDO) verbunden, wobei das mit dem ferngesteuerten Überwachungszentrum (MC) verbundene Mikroprozessor-Steuergerät (MCU) über individuelle Leitungen an Eingänge der Steuerung und Hochstromschütze (P1, Pn) und Kleinstromschütze (p1, pN) und an Kommunikationsschnittstelle (T1) des Kontroll- und Messgeräts (TBA-ST) angeschlossen ist.

2. Verfahren nach dem Patentanspruch 1, **dadurch gekennzeichnet, dass** das Mikroprozessor-Steuergerät (MCU) über einen der Hochstromschütze (P1, Pn) die zu testende Batterie (B1, Bn) von der Minus-Systemschiene (-) trennt und sie über den entsprechenden Kleinstromschütz (p1, pN) mit dem ersten Eingang (-B) des Kontroll- und Messgeräts (TSA-ST) verbindet, wobei nach Beendigung der Prüfung die Batterie vom Kontroll- und Messgerät (TBA-ST) getrennt und über den Hochstromschütz (P1, Pn) mit der Minus-Systemschiene verbunden wird.

3. Verfahren nach dem Patentanspruch 1, **dadurch gekennzeichnet, dass** das Kontroll- und Messgerät auf Anforderung des Mikroprozessor-Steuergeräts (MCU) autonom einen Test durchführt bestehend aus der Entladung der Batterie (B1, Bn) mit dem über das interne Strommess-Subsystem gesteuerten Strom (LEM), indem die Energie der Batterie (B1, Bn) zum Aufladen (LD) des Versorgungssystem verwendet wird, wobei anschließend die Energie von Gleichrichtern (PR1, PRn) übernommen wird und die Batterie über das Strommess-Subsystem (LEM) mit dem 10-Stunden- oder 20-Stunden-Strom auf die festgelegte Spannung geladen wird, wobei nach Ablauf der festgelegten Ladezeit der Prozess beendet wird und das Gesamtergebnis des Ladeprozesses an das Mikroprozessor-Steuergerät (MSU) übermittelt wird.

4. Verfahren nach dem Patentanspruch 1, **dadurch gekennzeichnet, dass** das Kontroll- und Messgerät (TBA-ST) auf Befehl des Mikroprozessor-Steuergeräts (MCU) nur eine Ausgleichsladung der Batterie (B1, Bn) durchführt und nach Ablauf der festgelegten Zeit das Gesamtergebnis des Ladeprozesses an das Mikroprozessor-Steuergerät (MCU) übermittelt wird.

5. Verfahren nach Anspruch 1, **dadurch gekennzeichnet, dass** beim Batterieladeprozess das Kontroll- und Messgerät (TBA-ST) bei Spannungsausfall im Stromnetz auf die Batterieentladung schaltet und die Versorgung für das Laden (LD) des Versorgungssystems (PS) mittels der in der Batterie (B1, Bn) gespeicherten Energie aufrecht erhalten wird, wobei der interne additiv-subtrahierende Konverter (PDO) autonom kontrolliert wird sodass die Spannung am dritten Ausgang (-S) des Konverters der Spannung an der Minus-Systemschiene (-) entspricht und dass von der vom Test getrennten Batterie (B1, Bn) der festgelegte Strom entnommen wird.

6. Verfahren nach Anspruch 5, **dadurch gekennzeichnet, dass** im Batterietestprozess das Kontroll- und Messgerät (TBA-ST) nach Erkennung der Wiederherstellung der Spannung im Stromnetz durch die Erhöhung der Spannung an der Minus-Systemschiene (-) oder Signal des Mikroprozessor-Steuergeräts (MCU) entweder das Entladen der Batterie (B1, Bn) fortsetzt oder das Batterieladen in Verbindung mit dem Ausgleichsladen durchführt.

7. Verfahren nach einem der Ansprüche 1 bis 5, **dadurch gekennzeichnet, dass** das Endergebnis der Messung der verfügbaren Kapazität an das Mikroprozessor-Steuergerät und, im nächsten Schritt, an das ferngesteuerte Überwachungszentrum übermittelt wird.

8. System zur ferngesteuerten Messung der verfügbaren Batteriekapazität im Telekommunikation-Versorgungssystem, **dadurch gekennzeichnet, dass** es aus dem Versorgungssystem (PS), das mit der Ladungssystem (LD) und dem ferngesteuerten Überwachungszentrum (MC) verbunden ist, das über die Übertragungsleitung oder Netzwerk mit dem Mikroprozessor-Steuergerät (MCU) verbunden ist, Gleichrichtern (PR1, PRn) und mindestens zwei Batterien (B1, Bn), die über Schütze angeschlossen sind, wobei die Plus-Kontakte der Batterien (B1, Bn) mit der Plus-Schiene (+) der Versorgung (PS) verbunden sind, Plus-Ladepolen (LD) und Plus-Gleichrichterausgängen (PR1, PRn) besteht; die Minus-Ausgänge sind mit der Minus-Schiene (-) der Versorgung (PS) verbunden, wobei diese Minus-Schiene auch mit den Minus-Ladepolen (LD) verbunden ist, wobei die Minus-Schiene (-) der Versorgung (PS) mit individuellen Klemmen jeder der Batterien (B1, Bn) verbunden ist, ebenso mit den Hochstromschützen (P1, Pn), deren zweite Kontakte direkt oder über Sicherungen mit Minus-Polen der jeweiligen Batterie (B1, Bn) verbunden sind, wo diese Pole über Kleinstromschütze (p1, pN) direkt, bevorzugt über Sicherungen, mit dem zweiten Eingang (-B) des Kontroll- und Messgeräts (TBA-ST) verbunden sind, das mit dem dritten Eingang (-S) mit der Minus-Schiene (-) und mit dem ersten Eingang (M) mit der Plus-Schiene (+) des Systems verbunden sind, wobei der dritte Eingang (-S) mit dem dritten Eingang (3) des additiv-subtrahierenden Konverters (PDO) verbunden ist und das zweite Eingang (-B) über das Strommesssystem (LEM) mit dem zweiten Eingang (2) des additiv-subtrahierenden Konverters (PDO) verbunden ist, wo das Mikroprozessor-Steuergerät (MCU) über individuelle Leitungen mit Steuerleitungen der Hochstromschütze (P1, Pn) und der Kleinstromschütze (p1, pN) sowie mit der Kommunikationsschnittstelle (T1) des Kontroll- und Messgeräts (TBA-ST) verbunden ist.

9. System nach Anspruch <?> **dadurch gekennzeichnet, dass** die Kleinstromschütze (p1, pN) mit dem Kontroll- und Messgerät (TBA-ST) integriert sind und durch dieses Kontroll- und Messgerät (TBA-ST) aktiviert werden.

## Revendications

1. Une méthode de mesure à distance de la capacité disponible des batteries dans le système d'alimentation de télécommunication, **caractérisée en ce qu'**elle est contrôlée à distance par un centre de télésurveillance (MC) connecté par une liaison de transmission ou par un réseau de données avec une unité de contrôle à microprocesseur (MCU), et comprend une décharge contrôlée de la batterie (B1, Bn) avec l'utilisation d'un dispositif de contrôle et de mesure (TBA-ST) avec un courant constant prédéterminé, où, afin d'initier à distance une décharge individuelle pour chacune d'au moins de deux batteries (B1, Bn), le bus système négatif (-) dans le système d'alimentation (PS) est connecté aux bornes individuelles pour chacune des batteries (B1, Bn), normalement mises en circuit et agissant comme des interrupteurs à basse tension, de contacteurs à courant élevé (P1, Pn), dont les deuxièmes contacts sont connectés, soit directement, soit à travers les fusibles, aux pôles négatifs de la batterie (B1, Bn), alors que ces pôles sont connectés par les contacteurs à courant faible (p1, pN), directement ou par l'intermédiaire des fusibles, à la deuxième entrée (B) du dispositif de contrôle et de mesure (TBA-ST) connecté par la troisième entrée (-S) au bus système négatif (-) et par la première entrée (M) au bus système positif (+), tandis que la troisième entrée (-S) du dispositif de contrôle et de mesure (TBA-ST) est connectée à la troisième entrée (3) du convertisseur additif-soustractif (PDO), la première entrée (M) du dispositif de contrôle et de mesure (TBA-ST) est connectée à l'entrée de masse (1) du convertisseur additif-soustractif (PDO), la deuxième entrée (-B) du dispositif de contrôle et de mesure (TBA-ST) est connectée par l'intermédiaire du sous-système de mesure de courant (LEM) à la deuxième entrée (2) du convertisseur additif-soustractif (PDO), tandis que l'unité de contrôle à microprocesseur (MCU) connectée au centre de télésurveillance (MC) est connectée par des lignes individuelles aux entrées de contrôle et contacteurs à courant élevé (P1, Pn), et contacteurs à courant faible (p1, pN), et à l'interface de communication (T1) du dispositif de contrôle et de mesure (TBA-ST).

2. La méthode selon la revendication 1, **caractérisée en ce que** l'unité de contrôle à microprocesseur (MCU) par l'intermédiaire de l'un des contacteurs à courant élevé (P1, Pn) déconnecte la batterie (B1, Bn) désignée pour le test à partir du bus système négatif (-), et par l'intermédiaire d'un contacteur respectif à faible courant (p1, pN) la connecte à la première entrée (-B) du dispositif de contrôle et de mesure (TBA-ST), et après avoir fini le test, la procédure déconnecte la batterie testée du dispositif de contrôle et de mesure (TBA-ST) et la connecte par l'intermédiaire du contacteur à courant élevé (P1, Pn) au bus système négatif (-).

3. La méthode selon la revendication 1, **caractérisée en ce que** le dispositif de contrôle et de mesure (TBA-ST) dans la commande depuis l'unité de contrôle à microprocesseur (MCU) effectue de manière autonome un test comprenant la décharge de la batterie (B1, Bn) désignée pour le test avec le courant contrôlé par un sous-système de mesure de courant interne (LEM), en dirigeant de l'énergie prélevée sur la batterie (B1, Bn) à la charge (LD) du système d'alimentation (PS), puis tout de suite, en prenant de l'énergie à partir des unités de redressement (PR1, PRn), charge la batterie avec le courant de 10 heures ou le courant de 20 heures contrôlé par le sous-système de mesure de courant (LEM) jusqu'à la tension préréglée, et après le temps de charge préréglé, il met fin au processus, en passant le résultat cumulé de tests à l'unité de contrôle à microprocesseur (MCU).

4. La méthode selon la revendication 1, **caractérisée en ce que** le dispositif de contrôle et de mesure (TBA-ST) dans la commande depuis l'unité de contrôle à microprocesseur (MCU) effectue uniquement l'égalisation de charge de la batterie (B1, Bn), et après une durée prédéfinie, il termine le processus, en passant le résultat cumulé de la charge à l'unité de contrôle à microprocesseur (MCU).

5. La méthode selon la revendication 1, **caractérisée en ce que** dans le procédé de test de la batterie, le dispositif de contrôle et de mesure (TBA-ST) à une perte de tension dans le réseau électrique passe au régime de décharge de la batterie, maintenant l'alimentation électrique à la charge (LD) du système d'alimentation (PA) avec de l'énergie stockée dans cette batterie (B1, Bn), alors qu'il contrôle de manière autonome le convertisseur additif-soustractif interne (PDO) de telle sorte que la tension sur la troisième sortie (-S) de ce convertisseur est égale à la tension sur le bus système négatif (-), et le courant prédéfini est pris depuis la batterie (B1, Bn) déconnectée pour le test.

6. La méthode selon la revendication 5, **caractérisée en ce que** dans le procédé de test de la batterie, le dispositif de contrôle et de mesure (TBA-ST), après avoir constaté que la tension est rétablie dans le réseau électrique par l'augmentation de la tension au niveau du bus système négatif (-) ou sur le signal provenant de l'unité de contrôle à microprocesseur (MCU), soit continue de décharger la batterie (B1, Bn), soit réalise sa charge combinée à l'égalisation de charge.

7. La méthode selon l'une quelconque des revendications 1-6, **caractérisée en ce que** le résultat final de mesure de la capacité disponible est envoyé à l'unité de contrôle à microprocesseur (MCU) et, à l'étape suivante, au centre de télésurveillance (MC).

8. Un système de mesure à distance de la capacité disponible des batteries dans le système d'alimentation de télécommunication, **caractérisé en ce qu'il** comprend le système d'alimentation (PS) qui est connecté à la charge (LD) et au centre de télésurveillance (MC) connecté par une liaison de transmission ou par un réseau de données avec l'unité de contrôle à microprocesseur (MCU), les unités de redressement (PR1, PRn) et au moins deux batteries (B1, Bn) connectées par l'intermédiaire des contacteurs, et où les bornes positives de la batterie (B1, Bn) sont connectées au bus système positif (+) du système d'alimentation (PS), aux pôles positifs de la charge (LD) et aux sorties positives des unités de redressement (PR1, PRn), dont les sorties négatives sont connectées au bus système négatif (-), qui est également connecté aux pôles négatifs de la charge (LD), et où le bus système négatif (-) du système d'alimentation (PS) est connecté aux bornes individuelles pour chacune des batteries (B1, Bn), aux contacteurs à courant élevé (P1, Pn), dont les deuxièmes contacts sont connectés, soit directement, soit à travers les fusibles, aux pôles négatifs de la batterie respective (B1, Bn), dans laquelle ces pôles sont connectés par les contacteurs à courant faible (P1, pN), directement, ou de préférence par l'intermédiaire des fusibles, à la deuxième entrée (-B) du dispositif de contrôle et de mesure (TBA-ST) connecté avec la troisième entrée (-S) au bus système négatif (-) et avec la première entrée (M) au bus système positif (+), dans lequel la troisième entrée (-S) est connectée à la troisième entrée (3) du convertisseur additif-soustractif (PDO), et la première entrée (M) est connectée à l'entrée de masse (1) du convertisseur additif-soustractif (PDO), et la deuxième entrée (-B) est connectée par l'intermédiaire du sous-système de mesure de courant (SEL) à la deuxième entrée (2) du convertisseur additif-soustractif (PDO), dans lequel l'unité de contrôle à microprocesseur (MCU) est connectée par des lignes individuelles avec les entrées de contrôle des contacteurs à courant élevé (P1, Pn) et les contacteurs à faible courant (p1, pN), et avec l'interface de communication (T1) du dispositif de contrôle et de mesure (TBA-ST).

9. Le système selon la revendication 8, **caractérisé en ce que** les contacteurs à courant faible (p1, pN) sont intégrés avec le dispositif de contrôle et de mesure (TBA-ST) et sont activés par ce dispositif de contrôle et de mesure (TBA-ST).
